# EUROPEAN PATENT APPLICATION

(11) **EP 4 328 939 A1**
(43) Date of publication of application: **28.02.2024**
(21) Application number: 21947492.1
(22) Date of filing: 29.06.2021
(51) Int. Cl.: H01B 12/00

(54) **MEMORY AND FORMING METHOD THEREFOR, AND ELECTRONIC APPARATUS**

(71) Applicant: Huawei Technologies Co., Ltd., Shenzhen, Guangdong 518129 (CN)
(72) Inventor: JING, Weiliang, Shenzhen, Guangdong 518129 (CN); HUANG, Kailiang, Shenzhen, Guangdong 518129 (CN); FENG, Junxiao, Shenzhen, Guangdong 518129 (CN); WANG, Zhengbo, Shenzhen, Guangdong 518129 (CN)
(74) Representative: Isarpatent
(86) International application number: PCT/CN2021/103316
(87) International publication number: WO 2023/272537

(57) **Abstract**

Embodiments of this application provide a memory and a forming method thereof, and an electronic device including the memory, mainly to increase storage density of the memory. The memory includes: a substrate and a plurality of storage units formed on the substrate. Each of the storage units includes a transistor and a capacitor electrically connected to the transistor. The transistor includes a gate, a semiconductor layer, a first electrode, a second electrode, and a gate dielectric layer. The first electrode and the second electrode are arranged in a first direction, the gate is located between the first electrode and the second electrode, the semiconductor layer is provided on one of two opposite sides of the gate in a second direction, the semiconductor layer is separately electrically connected to the first electrode and the second electrode, the gate and the semiconductor layer are isolated from each other by the gate dielectric layer, and the second direction is a direction parallel to the substrate. In this way, the semiconductor layer is provided on one of the two opposite sides of the gate in the second direction, so that an area occupied by each storage unit on the substrate can be reduced, thereby increasing storage density.

## Description

### TECHNICAL FIELD

This application relates to the field of semiconductor storage technologies, and in particular, to a memory and a forming method thereof, and an electronic device including the memory.

### BACKGROUND

In a computing system, a dynamic random access memory (dynamic random access memory, DRAM), as a memory structure, may be used to temporarily store computing data of a central processing unit (central processing unit, CPU), and exchange data with an external memory such as a hard disk, and is a very important part of the computing system.

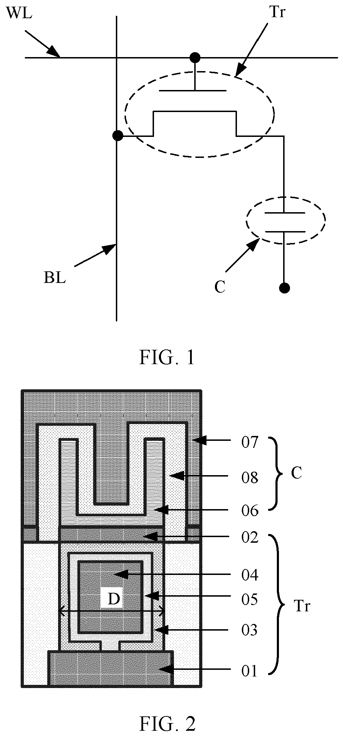

FIG. 1 is a circuit diagram of a storage unit in a DRAM. A storage unit mainly includes a transistor (transistor) and a capacitor (capacitor) electrically connected to the transistor. Such a storage unit structure may be referred to as a 1T1C storage unit. A transistor Tr is electrically connected to a bit line (bit line, BL) and a word line (word line, WL), the transistor Tr is configured to control connection or disconnection between the BL and a capacitor C, and the capacitor C is configured to store a charge.

FIG. 2 is a diagram of a process structure of the foregoing 1T1C storage unit. A transistor Tr includes a first electrode 01, a second electrode 02, and a semiconductor layer 03 (which may also be referred to as a channel layer) electrically connected to both the first electrode 01 and the second electrode 02, and further includes a gate 04, and a gate dielectric layer 05 that isolates the isolation semiconductor layer 03 from the gate 04. The capacitor C mainly includes a first electrode layer 06, a second electrode layer 07, and a capacitor dielectric layer 08 that isolates the first electrode layer 06 from the second electrode layer 07.

From the diagram of the process structure shown in FIG. 2, it can be learned that the gate dielectric layer 05 surrounds a periphery of the gate 04, and the semiconductor layer 03 surrounds a periphery of the gate dielectric layer 05, so that the semiconductor layer 03 forms a channel structure approximating to an annular structure. This causes a large size of the transistor Tr in a direction D shown in FIG. 2, and further causes a large bottleneck to a size reduction capability of the storage unit in the direction D. Consequently, increase of storage density is limited.

### SUMMARY

This application provides a memory and a forming method thereof, and an electronic device including the memory, to mainly provide a memory that can increase storage density and a storage capacity.

To achieve the foregoing objectives, the following technical solutions are used in embodiments of this application.

According to a first aspect, this application provides a memory. The memory may be a volatile DRAM. The memory includes: a substrate and a plurality of storage units formed on the substrate. Each of the storage units includes a transistor and a capacitor electrically connected to the transistor. For example, the capacitor may be a capacitor structure including two electrode layers and a capacitor dielectric layer disposed between the two electrode layers. In addition, the transistor and the capacitor are arranged in a first direction perpendicular to the substrate. The transistor includes a gate, a semiconductor layer, a first electrode, a second electrode, and a gate dielectric layer. The first electrode and the second electrode are arranged in the first direction, the gate is located between the first electrode and the second electrode, the semiconductor layer is provided on one of two opposite sides of the gate in a second direction, the semiconductor layer is separately electrically connected to the first electrode and the second electrode, the gate and the semiconductor layer are isolated from each other by the gate dielectric layer, and the second direction is a direction parallel to the substrate.

In the memory provided in this application, the transistor and the capacitor included in the memory are arranged in the direction perpendicular to the substrate. In this way, a projected area of the memory on the substrate can be reduced, so as to increase storage density and a storage capacity of the memory.

In addition, because the first electrode and the second electrode of the transistor are arranged in the direction perpendicular to the substrate, the semiconductor layer (which may also be referred to as a channel layer) electrically connected to the first electrode and the second electrode is of a vertical channel structure, and a storage unit is effectively miniaturized compared with that in a transistor of a horizontal channel.

Moreover, in particular, in the transistor, the semiconductor layer is disposed on one of the two opposite sides of the gate in the second direction, instead of providing semiconductors around the periphery of the gate. In this way, a size of the entire transistor in the second direction can be reduced, and the storage unit can be further miniaturized. Storage density of the memory is significantly increased and a storage capacity is increased based on these features, thereby increasing a read/write speed of the memory.

In a possible implementation of the first aspect, the semiconductor layer is of a vertical structure extending in the first direction, one of two opposite ends of the semiconductor layer in the first direction is in contact with the first electrode, and the other end is in contact with the second electrode.

The semiconductor layer is configured as a vertical structure, and is in ohmic contact with the first electrode and the second electrode, so that the semiconductor layer forms a vertical channel structure perpendicular to the substrate, thereby further enabling the storage unit to be miniaturized.

In a possible implementation of the first aspect, the semiconductor layer is of the vertical structure extending in the first direction, a surface that is in the first electrode and that faces the second electrode is a first wall surface, and a surface that is in the second electrode and that faces the first electrode is a second wall surface. One of the two opposite ends of the semiconductor layer in the first direction is in contact with the first wall surface, and the other end is in contact with the second wall surface.

In other words, the vertical semiconductor layer is disposed in a region between the first electrode and the second electrode.

In a possible implementation of the first aspect, the semiconductor layer is of the vertical structure extending in the first direction, a surface that is in the first electrode and that faces the second electrode is a first wall surface, and a surface that is in the first electrode and that is adjacent to the first wall surface is a first side surface. A surface that is in the second electrode and that faces the first electrode is a second wall surface, a surface that is in the second electrode and that is adjacent to the second wall surface is a second side surface, and the first side surface and the second side surface are located on a same side. One of the two opposite ends of the semiconductor layer in the first direction is in contact with the first side surface, and the other end is in contact with the second side surface.

In this way, the semiconductor layer is erected on one side of the first electrode and the second electrode.

In a possible implementation of the first aspect, the semiconductor layer includes a first portion and a second portion both of which extend in the second direction, and a third portion that extends in the first direction and that is connected to the first portion and the second portion. A surface that is in the first electrode and that faces the second electrode is a first wall surface, and a surface that is in the second electrode and that faces the first electrode is a second wall surface. The first portion is disposed on the first wall surface, and the second portion is disposed on the second wall surface.

In this way, from a perspective of performance of the formed storage unit, a contact area between the semiconductor layer and each of the first electrode and the second electrode may be increased, so as to reduce resistance between the first electrode and the semiconductor layer and resistance between the second electrode and the semiconductor layer, increase a current flow rate, and finally increase a read/write speed of the storage unit. From a perspective of a process of forming the storage unit, a manufacturing process flow may be simplified, and a process difficulty may be reduced.

In a possible implementation of the first aspect, the first portion, the second portion, and the third portion are connected to form an integral structure.

In a possible implementation of the first aspect, the semiconductor layer includes a first portion extending in the second direction and a third portion that extends in the first direction and that is connected to the first portion. A surface that is in the first electrode and that faces the second electrode is a first wall surface, and a surface that is in the second electrode and that faces the first electrode is a second wall surface. The memory further includes a connection electrode, and the connection electrode is disposed on the second wall surface. The third portion is in contact with the first wall surface, and the first portion is in contact with the connection electrode.

In other words, both the semiconductor layer and the gate dielectric layer are designed to be of a structure approximating to an L-shaped structure. From a perspective of a process of forming the storage unit, etching process steps in a producing procedure can be reduced, thereby improving manufacturing efficiency.

In a possible implementation of the first aspect, the surface that is in the first electrode and that faces the second electrode is the first wall surface, and the surface that is in the second electrode and that faces the first electrode is the second wall surface. The gate is located in a region between the first wall surface and the second wall surface.

The gate is disposed in a region between the first electrode and the second electrode, so that a projected area of the storage unit on the substrate can be further reduced, so as to further increase integration density.

In a possible implementation of the first aspect, the surface that is in the first electrode and that faces the second electrode is the first wall surface, and the surface that is in the first electrode and that is adjacent to the first wall surface is the first side surface. The surface that is in the second electrode and that faces the first electrode is the second wall surface, the surface that is in the second electrode and that is adjacent to the second wall surface is the second side surface, and the first side surface and the second side surface are located on the same side. The gate is located on a side close to the first side surface and the second side surface.

In a possible implementation of the first aspect, both the transistor and the capacitor are manufactured by using a back end of line process.

When both the transistor and the capacitor are manufactured by using the back end of line process, the control circuit is manufactured by using a front end of line process. The control circuit may include one or more of circuits: a decoder, a driver, a timing controller, a cache, or an input/output driver, and may further include another functional circuit. The control circuit may control a signal line in this embodiment of this application, to be specific, a word line, a bit line, and the like. After the front end of line FEOL process is completed, interconnects and a storage array are manufactured by using the back end of line BEOL process. The storage array herein, as described above, includes a transistor and a capacitor in a storage unit, and also includes a part of a signal line. The interconnects include not only interconnects connecting components in the control circuit, but also include another part of the signal line. The transistor in the storage array is manufactured by using the back end of line process, so that circuit density per unit area can be higher, thereby improving performance per unit area.

In a possible implementation of the first aspect, the capacitor includes a first electrode layer, a capacitor dielectric layer, and a second electrode layer, the first electrode layer and the second electrode layer are isolated from each other by the capacitor dielectric layer, and the first electrode layer is electrically connected to the first electrode that is in the transistor and that is close to the capacitor.

A voltage difference between the first electrode layer and the second electrode layer enables the capacitor dielectric layer to store a charge.

In a possible implementation of the first aspect, the first electrode layer extends in the first direction, and the second electrode layer surrounds a periphery of the first electrode layer.

To be specific, the capacitor is of a column structure perpendicular to the substrate. Certainly, the capacitor may be alternatively in another shape.

In a possible implementation of the first aspect, the memory further includes bit lines and word lines, where the gate is electrically connected to the word lines, and the second electrode is electrically connected to the bit lines.

In a possible implementation of the first aspect, the bit lines all extend in the second direction; the word lines extend in a third direction, and the second direction is perpendicular to the third direction; the second electrodes of the plurality of storage units arranged in the second direction are electrically connected to a same bit line; and the gates of the plurality of storage units arranged in the third direction are electrically connected to a same word line.

In a possible implementation of the first aspect, during data reading, a bit line BL is charged to half of an operating voltage, and then a transistor Tr is turned on, so that the bit line BL and a capacitor C generate a charge sharing phenomenon. If a value stored in a selected storage unit 400 is " 1", a voltage of the bit line BL is pulled up to be higher than half of the operating voltage by charge sharing; otherwise, if a value stored in the selected storage unit 400 is "0", the voltage of the bit line BL is pulled down to be lower than half of the operating voltage. After the voltage of the bit line BL is obtained, it is determined whether the read data is "1" or "0". When data is written, the transistor Tr is turned on. If " 1" is to be written, the voltage of the bit line BL is pulled up to the operating voltage, so that a charge is stored in the capacitor C. If "0" is to be written, the bit line BL is reduced to 0 volts, so that no charge is stored in the capacitor C.

In a possible implementation of the first aspect, the memory further includes a controller. The controller is configured to: output a word line control signal to control a voltage on each of the word lines; and output a bit line control signal to control a voltage on each of the bit lines. In other words, the controller and the storage array structure used for storage are integrated into a same chip.

According to a second aspect, this application further provides an electronic device, including a processor and the memory in any implementation of the first aspect. The processor is electrically connected to the memory.

The electronic device provided in this embodiment of this application includes the memory in the embodiment of the first aspect. Therefore, the electronic device provided in this embodiment of this application and the memory in the foregoing technical solution can resolve a same technical problem, and achieve same expected effect.

In a possible implementation of the second aspect, the processor and the memory are integrated into a same chip.

The memory formed in this way may be referred to as an embedded storage structure.

According to a third aspect, this application further provides a memory forming method. The forming method includes:
forming a first electrode and a second electrode in a first direction perpendicular to a substrate, and forming a semiconductor layer, a gate, and a gate dielectric layer, where the semiconductor layer is provided on one of two opposite sides of the gate in a second direction, the semiconductor layer is separately electrically connected to the first electrode and the second electrode, and the gate dielectric layer is formed between the gate and the semiconductor layer, to form a transistor, where the second direction is a direction parallel to the substrate; and
forming a capacitor, and making the capacitor electrically connected to the transistor, so as to produce a storage unit.

In the memory forming method, because the semiconductor layer is provided on one of the two opposite sides of the gate in the second direction, a size of the entire transistor in the second direction can be reduced, and the storage unit can be further miniaturized. Storage density of the memory is significantly increased and a storage capacity is increased based on these features, thereby increasing a read/write speed of the memory.

It should be emphasized that, in the foregoing procedure of producing the storage unit of the memory, a capacitor may be produced first, and then a transistor is produced on a side that is of the capacitor and that is away from the substrate, so as to produce a storage unit disposed close to the substrate by the capacitor relative to the transistor; or a transistor may be produced first, and then a capacitor is produced on a side that is of the transistor and that is away from the substrate, so as to produce a storage unit disposed close to the substrate by the transistor relative to the capacitor.

In a possible implementation of the third aspect, before the storage unit is formed, the forming method further includes: forming a control circuit on the substrate; and forming, on the control circuit, interconnects that electrically connect the control circuit and the storage unit.

In this way, the control circuit is manufactured on the substrate by using a front end of line (front end of line, FEOL) process, a storage array is manufactured on the control circuit by using a back end of line (back end of line, BEOL) process, and the control circuit is electrically connected to the storage array by using interconnects.

In a possible implementation of the third aspect, when the transistor is formed, the method includes: sequentially stacking a first conductive layer, a sacrificial layer, and a second conductive layer in the first direction; providing a first slot that passes through the second conductive layer, the sacrificial layer, and the first conductive layer; sequentially forming the gate dielectric layer and the gate on a side wall surface of the first slot in the second direction parallel to the substrate; removing the sacrificial layer in contact with the gate dielectric layer, to form a concave cavity, where the first electrode and the second electrode are formed on two sides of the concave cavity; and forming the semiconductor layer on a wall surface that is of the concave cavity and that is at least close to the gate dielectric layer, to produce the transistor.

In a possible implementation of the third aspect, when the transistor is formed, the method includes: sequentially stacking a first conductive layer, a sacrificial layer, and a second conductive layer in the first direction; providing a first slot that passes through the second conductive layer, the sacrificial layer, and the first conductive layer; forming the semiconductor layer on a side wall surface of the first slot in the second direction parallel to the substrate; removing the sacrificial layer in contact with the semiconductor layer, to form a concave cavity, where the first electrode and the second electrode are formed on two sides of the concave cavity; and forming, in the concave cavity, the gate and the gate dielectric layer for isolating the gate from the semiconductor layer, so as to produce the transistor.

In a possible implementation of the third aspect, when the transistor is formed, the method includes: sequentially stacking a first conductive layer, a sacrificial layer, and a second conductive layer in the first direction; providing a first slot that passes through the second conductive layer, the sacrificial layer, and the first conductive layer; removing the sacrificial layer to form a concave cavity, where the first electrode and the second electrode are formed on two sides of the concave cavity; and forming, in the concave cavity, the semiconductor layer, the gate, and the gate dielectric layer for isolating the gate from the semiconductor layer, so as to produce the transistor.

In a possible implementation of the third aspect, when the transistor is formed, the method includes: sequentially stacking a first conductive layer, a sacrificial layer, and a second conductive layer in the first direction; providing a first slot that ends at the first conductive layer; sequentially forming the gate dielectric layer and the semiconductor layer on a side surface of the first slot, so that the gate is formed on the second conductive layer, and the first electrode is formed on the first conductive layer; and forming the second electrode on the semiconductor layer, to produce the transistor.

### BRIEF DESCRIPTION OF DRAWINGS

FIG. 1 is a circuit diagram of a storage unit in a DRAM;
FIG. 2 is a diagram of a process structure of a storage unit in a DRAM in the conventional technology;
FIG. 3 is a circuit diagram of an electronic device according to an embodiment of this application;
FIG. 4 is a circuit diagram of a DRAM according to an embodiment of this application;
FIG. 5 is a circuit diagram of a storage array of a DRAM according to an embodiment of this application;
FIG. 6a is a diagram of a process structure of a storage unit in a DRAM according to an embodiment of this application;
FIG. 6b is a cross-sectional view of FIG. 6a in an A-A direction;
FIG. 7 is a schematic top view of a storage array of a DRAM according to an embodiment of this application;
FIG. 8a is a diagram of a process structure of a storage unit in a DRAM according to an embodiment of this application;
FIG. 8b is a cross-sectional view of FIG. 8a in a B-B direction;
FIG. 9a is a diagram of a process structure of a storage unit in a DRAM according to an embodiment of this application;
FIG. 9b is a cross-sectional view of FIG. 9a in a D-D direction;
FIG. 10a is a diagram of a process structure of a storage unit in a DRAM according to an embodiment of this application;
FIG. 10b is a cross-sectional view of FIG. 10a in an E-E direction;
FIG. 11a is a diagram of a process structure of a storage unit in a DRAM according to an embodiment of this application;
FIG. 11b is a cross-sectional view of FIG. 11a in an F-F direction;
FIG. 12a is a diagram of a process structure of a storage unit in a DRAM according to an embodiment of this application;
FIG. 12b is a cross-sectional view of FIG. 12a in a G-G direction;
FIG. 13 is a three-dimensional diagram of a process structure of a storage array part of a DRAM according to an embodiment of this application;
FIG. 14 is a conceptual diagram of a process of a chip according to an embodiment of this application;
FIG. 15 is a three-dimensional diagram of a process structure of a part of a DRAM according to an embodiment of this application;
FIG. 16a to FIG. 16h are diagrams of a process structure after steps of forming a storage unit are completed according to an embodiment of this application;
FIG. 17a to FIG. 17h are diagrams of a process structure after steps of forming a storage unit are completed according to an embodiment of this application;
FIG. 18a to FIG. 18j are diagrams of a process structure after steps of forming a storage unit are completed according to an embodiment of this application;
FIG. 19a to FIG. 19k are diagrams of a process structure after steps of forming a storage unit are completed according to an embodiment of this application; and
FIG. 20a to FIG. 20i are diagrams of a process structure after steps of forming a storage unit are completed according to an embodiment of this application.

### Reference numerals:

01: first electrode; 02: second electrode; 03: semiconductor layer; 04: gate; 05: gate dielectric layer; 06: first electrode layer; 07: second electrode layer; 08: capacitor dielectric layer;
100: substrate; 200: control circuit; 310: storage array; 400: storage unit; 51: first electrode; 52: second electrode; 53: semiconductor layer; 531: first portion; 532: second portion; 533: third portion; 54: gate dielectric layer; 55: gate; 57: sacrificial layer; 561, 562, 563, 564, 581, 582: insulation layer; 59: connection electrode; 71: first electrode layer; 72: second electrode layer; 73: capacitor dielectric layer; 6: conductive layer; 101: first slot; 102: second slot; 103: concave cavity; 104: third slot.

### DESCRIPTION OF EMBODIMENTS

A dynamic random access memory (dynamic random access memory, DRAM) is a volatile memory (volatile memory) device. An advantage of the DRAM is that a structure is simple, to be specific, data of each bit (Bit) needs to be processed by only one capacitor and one transistor. Compared with a structure in which one bit in a static random access memory (static random access memory, SRAM) usually needs to be processed by six transistors, the DRAM has very high integration density and a relatively high capacity per unit volume, and therefore has a relatively low cost.

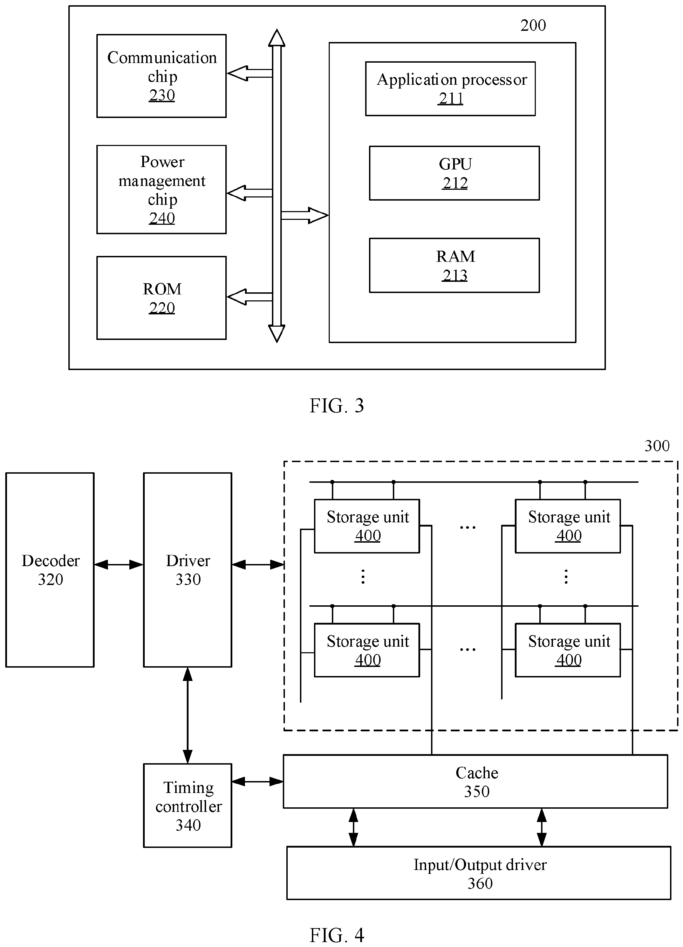

An embodiment of this application provides an electronic device including a DRAM. FIG. 3 is a conceptual diagram of an electronic device 200 according to an embodiment of this application. The electronic device 200 may be a terminal device, for example, a mobile phone, a tablet computer, or a smart band; or may be a personal computer (personal computer, PC), a server, a workstation, or the like. As shown in FIG. 3, the electronic device 200 includes a bus 205, and a system on chip (system on chip, SOC) 210 and a read-only memory (read-only memory, ROM) 220 that are connected to the bus 205. The SOC 210 may be configured to process data, for example, process data of an application program, process image data, and cache temporary data. The ROM 220 may be configured to store non-volatile data, for example, an audio file or a video file. The ROM 220 may be a PROM (programmable read-only memory, programmable read-only memory), an EPROM (erasable programmable read-only memory, erasable programmable read-only memory), a flash memory (flash memory), or the like.

In addition, the electronic device 200 may further include a communication chip 230 and a power management chip 240. The communication chip 230 may be configured to process a protocol stack, or perform processing such as amplification and filtering on an analog radio frequency signal, or implement the foregoing functions at the same time. The power management chip 240 may be configured to supply power to another chip.

In an implementation, the SOC 210 may include an application processor (application processor, AP) 211 configured to process an application program, a graphics processing unit (graphics processing unit, GPU) 212 configured to process image data, and a random access memory (random access memory, RAM) 213 configured to cache data.

The AP 211, the GPU 212, and the RAM 213 may be integrated into one die (die), or may be integrated into a plurality of dies (dies), and are packaged in one packaging structure, for example, by using 2.5D (dimension) packaging, 3D (dimension) packaging, or another advanced packaging technology. In an implementation, the AP 211 and the GPU 212 are integrated into one die, the RAM 213 is integrated into another die, and the two dies are packaged in one packaging structure, to obtain a higher inter-die data transmission rate and a higher data transmission bandwidth.

FIG. 4 is a schematic diagram of a structure of a DRAM 300 according to an embodiment of this application. In an implementation, the DRAM 300 may be a RAM disposed outside the SOC 210. A position of the DRAM 300 in the device and a position relationship between the DRAM 300 and the SOC 210 are not limited in this application.

Still as shown in FIG. 4, the DRAM 300 includes a storage array 310, a decoder 320, a driver 330, a timing controller 340, a cache 350, and an input/output driver 360. The storage array 310 includes a plurality of storage units 400 arranged in an array, and each storage unit 400 may be configured to store 1-bit data. The storage array 310 further includes a signal line: a word line (word line, WL) and a bit line (bit line, BL). Each storage unit 400 is electrically connected to a corresponding word line WL and a corresponding bit line BL. One or more of the word line WL and the bit line BL are used to select, by receiving a control level output by a control circuit, a storage unit 400 to be read from or to be written into the storage array. For convenience, in this embodiment of this application, the word line WL and the bit line BL are collectively referred to as the signal line.

In the structure of the DRAM 300 shown in FIG. 4. The decoder 320 is configured to perform decoding based on a received address, to determine a storage unit 400 to be accessed. The driver 330 is used to control a level of a signal line based on a decoding result generated by the decoder 320, so as to access the specified storage unit 400. The cache 350 is configured to cache read data, for example, may be configured to cache the read data in a first-in first-out (first-in first-out, FIFO) manner. The timing controller 340 is configured to control timing of the cache 350, and control the driver 330 to drive a signal line in the storage array 310. The input/output driver 360 is configured to drive a transmission signal, for example, drive a received data signal and a to-be-sent data signal, so that the data signal can be transmitted over a long distance.

The storage array 310, the decoder 320, the driver 330, the timing controller 340, the cache 350, and the input/output driver 360 may be integrated into one chip, or may be integrated into a plurality of chips.

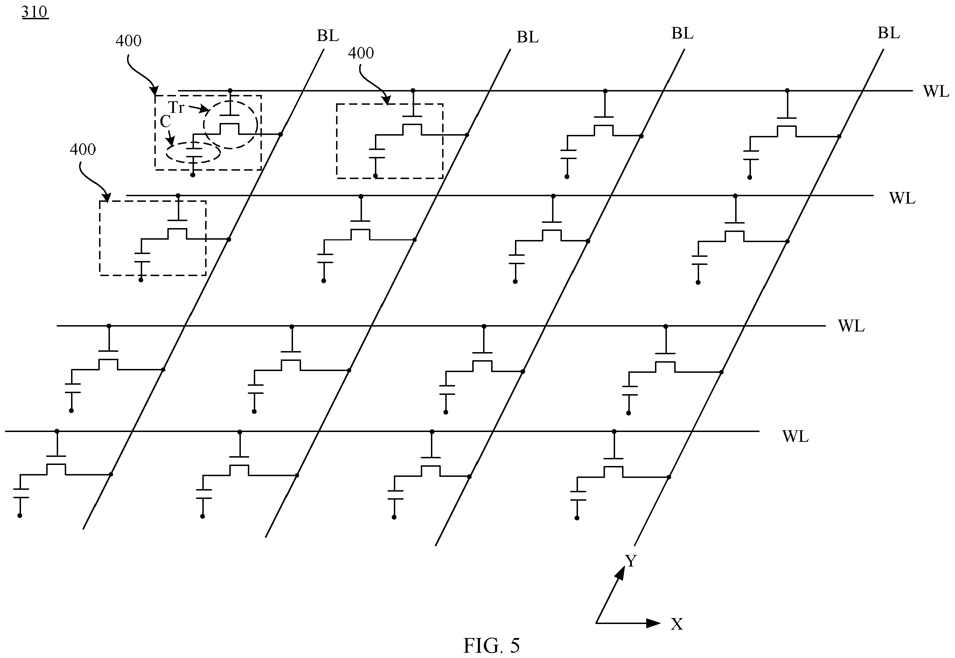

FIG. 5 is a circuit diagram of a part of storage arrays 310 in a DRAM 300. For example, FIG. 5 shows a matrix of 4 x 4. Each storage unit 400 in the storage array 310 includes a transistor Tr and a capacitor C. A control end of the transistor Tr in each storage unit 400 is electrically connected to a word line WL, a first electrode of the transistor Tr is electrically connected to the capacitor C, and a second electrode of the transistor Tr is electrically connected to a bit line BL.

In this embodiment of this application, a control end of the transistor Tr is a gate, one of a drain (drain) or a source (source) of the transistor Tr is referred to as a first electrode, and correspondingly, the other electrode is referred to as a second electrode. Actually, for a PMOS (P-channel metal oxide semiconductor, P-channel metal oxide semiconductor) transistor, it may be considered that one of the first electrode and the second electrode with a lower voltage is a source, and the other with a higher voltage is a drain. Correspondingly, for an NMOS (N-channel metal oxide semiconductor, N-channel metal oxide semiconductor) transistor, it may be considered that one of the first electrode and the second electrode with a lower voltage is a drain, and the other with a higher voltage is a source.

An operation mechanism of the storage unit 400 in the DRAM 300 is classified into read (Read) and write (Write). During data reading, a bit line BL is charged to half of an operating voltage, and then a transistor Tr is turned on, so that the bit line BL and a capacitor C generate a charge sharing phenomenon. If a value stored in a selected storage unit 400 is "1", a voltage of the bit line BL is pulled up to be higher than half of the operating voltage by charge sharing; otherwise, if a value stored in the selected storage unit 400 is "0", the voltage of the bit line BL is pulled down to be lower than half of the operating voltage. After the voltage of the bit line BL is obtained, it is determined whether the read data is "1" or "0". When data is written, the transistor Tr is turned on. If " 1 " is to be written, the voltage of the bit line BL is pulled up to the operating voltage, so that a charge is stored in the capacitor C. If "0" is to be written, the bit line BL is reduced to 0 volts, so that no charge is stored in the capacitor C.

With continuous evolution of an integrated circuit technology in an electronic device, a quantity of transistors per unit area on a chip of the electronic device continuously increases, so that performance of the electronic device is continuously optimized. In one aspect, an amount of data that can be calculated by the processor in a unit time continuously increases. For example, an amount of data that can be calculated by the GPU 212 in FIG. 3 rapidly increases. In another aspect, storage density of the memory also continuously increases, so as to meet a data processing requirement in the information era. However, because a logical unit in the processor and a storage unit in the memory are different in structures and processes, performance improvement degrees of the processor and the memory are different. To be specific, storage density of the memory is relatively low, and a read/write speed cannot keep up with an operation speed of the processor. This limits rapid improvement of performance of the electronic device.

An embodiment of this application provides a structure of a DRAM. The DRAM has relatively large storage density, a relatively high storage capacity, and a relatively high read/write speed, so that a difference from improvement of processor performance can be reduced.

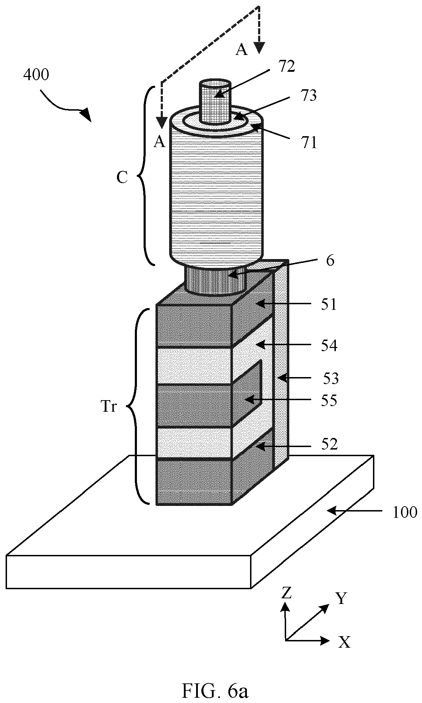

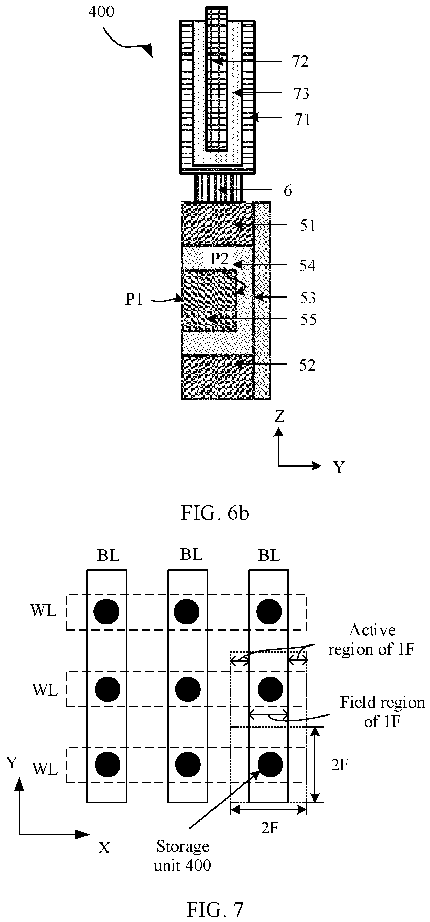

FIG. 6a is a three-dimensional diagram of a process structure of a storage unit 400 and a substrate 100 in a DRAM. FIG. 6b is a cross-sectional view of FIG. 6a in an A-A direction.

With reference to FIG. 6a and FIG. 6b, the storage unit 400 includes a transistor Tr and a capacitor C electrically connected to the transistor Tr, and the transistor Tr and the capacitor C are arranged in a direction perpendicular to the substrate 100 (for example, a Z direction in FIG. 6a). In this way, a projected area of the storage unit 400 on the substrate 100 can be reduced, thereby increasing storage density and a storage capacity.

It should be noted that, in various diagrams of a process structure of the storage unit provided in this application, as shown in FIG. 7a, a direction that is considered to be perpendicular to the substrate 100 is a Z direction, and a direction that is considered to be parallel to the substrate 100 includes an X direction and a Y direction that are perpendicular to each other.

The transistor Tr shown in FIG. 6a and FIG. 6b includes a first electrode 51, a second electrode 52, a semiconductor layer 53, a gate 55, and a gate dielectric layer 54. The semiconductor layer 53 herein may also be referred to as a channel layer. In other words, the transistor Tr herein is a transistor device having three terminals. Therefore, the transistor Tr may be an NMOS transistor, or may be a PMOS transistor.

With continued reference to FIG. 6a and FIG. 6b, the first electrode 51 and the second electrode 52 in the transistor Tr are arranged in the Z direction perpendicular to the substrate 100, the gate 55 is located between the first electrode 51 and the second electrode 52, the gate 55 is insulated from the first electrode 51, and the gate 55 is insulated from the second electrode 52.

In particular, the semiconductor layer 53 is provided on one of two opposite sides of the gate 55 provided in this application in a direction parallel to the substrate 100 (for example, the Y direction in FIG. 6a and FIG. 6b), the semiconductor layer 53 is separately electrically connected to the first electrode 51 and the second electrode 52, and the gate 55 and the semiconductor layer 53 are isolated from each other by the gate dielectric layer 54.

The feature "the semiconductor layer 53 is provided on one of the two opposite sides of the gate 55 in the Y direction parallel to the substrate 100" may be understood in the following way. As shown in FIG. 6b, two opposite side surfaces of the gate 55 in the Y direction are respectively a side surface P1 and a side surface P2, and the semiconductor layer 53 is located on the side surface P2, or the semiconductor layer 53 is located on the side surface P1. In other words, the semiconductor layer 53 is provided on one of the side surface P1 and the side surface P2 of the gate 55, and the semiconductor layer 53 is not provided on the other side surface, or the semiconductor layer 53 is not provided around a periphery of the gate 55.

A position relationship between the gate 55 and the semiconductor layer 53 in a process structure is designed in this way, so that a size of the transistor Tr in the Y direction can be reduced. In this way, the size of the transistor can be reduced, high-density integration of the storage unit can be implemented, and a storage capacity can be increased. Correspondingly, a read/write speed of the memory can be increased, and a degree of mismatch with development of the processor can be reduced. When storage density is increased, a higher data transmission bandwidth can be implemented when a storage capacity is increased.

In addition, because the first electrode 51 and the second electrode 52 in the transistor Tr are arranged in the Z direction perpendicular to the substrate 100, the semiconductor layer 53 electrically connected to the first electrode 51 and the second electrode 52 is a vertical channel structure perpendicular to the substrate 100. Compared with that in an existing transistor structure of a horizontal channel, a projected area of the transistor structure on the substrate may be smaller, so as to integrate more storage units in a unit area of the substrate, and further increase the storage density. For example, as shown in FIG. 7, a storage unit 400 in the memory has only an active region of 1F and a field region of 1F in an X direction and a Y direction, respectively. A last storage unit 400 occupies 2F x 2F = 4F² regions. With continuous miniaturization of a semiconductor device, compared with another storage unit occupying 6F² or a storage unit occupying a larger area, the last storage unit 400 has significant superiority in increasing storage density.

In addition, both the first electrode 51 and the second electrode 52 herein are a film layer structure. For example, the first electrode 51 and the second electrode 52 may be produced by using a deposition or sputtering process, instead of being made by doping in the substrate 100. In this way, the storage unit 400 may implement three-dimensional (3D) stacking on the substrate 100, so as to implement high-density integration.

Materials of the first electrode 51 and the second electrode 52 are both conductive materials, for example, metal materials. In an optional implementation, the materials of the first electrode 51 and the second electrode 52 may be one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver).

A material of the gate 55 is a conductive material, for example, a metal material. In an optional implementation, the material of the gate 55 may be one or more of conductive materials such as TiN (titanium nitride), Ti (titanium), Au (gold), W (tungsten), Mo (molybdenum), In-Ti-O (ITO, indium tin oxide), Al (aluminum), Cu (copper), Ru (ruthenium), and Ag (silver).

A material of the semiconductor layer 53 may be one or more of semiconductor materials such as Si (silicon), poly-Si (p-Si, polycrystalline silicon), amorphous-Si (a-Si, amorphous silicon), In-Ga-Zn-O (IGZO, indium gallium zinc oxide) multi-composite compound, ZnO (zinc oxide), ITO (indium tin oxide), TiO₂ (titanium dioxide), MoS₂ (molybdenum dioxide), and WS₂ (tungsten disulfide).

A material of the gate dielectric layer 54 may be one or more of insulation materials such as SiO₂ (silicon dioxide), Al₂O₃ (aluminum oxide), HfO₂ (hafnium dioxide), ZrO₂ (zirconia), TiO₂ (titanium dioxide), Y₂O₃ (yttrium oxide), and Si₃N₄ (silicon nitride).

The insulation material used to insulate the gate 55 from the first electrode 51 and the insulation material used to insulate the gate 55 from the second electrode 52 may be one or more of materials such as SiO₂, Si₃N₄, and Al₂O₃.

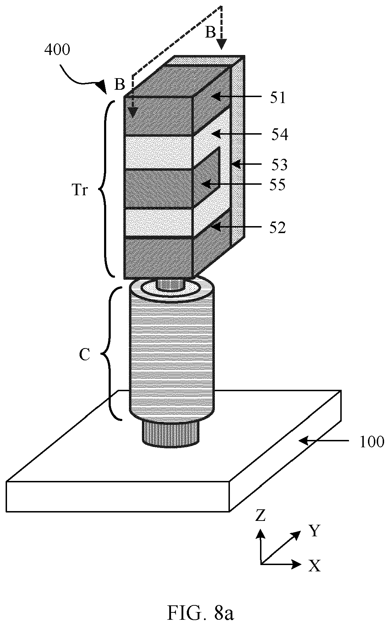

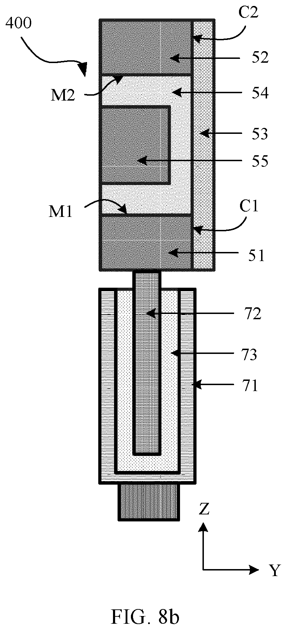

In the storage unit 400 provided in this application, a position relationship between the transistor Tr, the capacitor C, and the substrate 100 may be a relationship shown in FIG. 6a and FIG. 6b. To be specific, the transistor Tr is disposed close to the substrate 100 relative to the capacitor C. In some other optional implementations, layout manners shown in FIG. 8a and FIG. 8b may be used. FIG. 8b is a cross-sectional view of FIG. 8a in a B-B direction. In other words, the transistor Tr may be disposed away from the substrate 100 relative to the capacitor C.

The semiconductor layer 53 and the gate 55 provided in this application have a plurality of implementable structures. The following separately provides explanations with reference to the accompanying drawings.

With reference to FIG. 8b, the semiconductor layer 53 is of a vertical structure extending in the Z direction perpendicular to the substrate, the first electrode 51 has a first wall surface M1 that faces the second electrode 52, and the second electrode 52 has a second wall surface M2 that faces the first electrode 51. In addition, the first electrode 51 has a first side surface C1 adjacent to the first wall surface M1, and the second electrode 52 has a second side surface C2 adjacent to the second wall surface M2. The first side surface C1 and the second side surface C2 are located on a same side, and the semiconductor layer 53 is located on one of the first side surface C1 and the second side surface C2. One of the two opposite ends of the semiconductor layer 53 in the Z direction is in contact with the first side surface C1 to be coupled and electrically connected, and the other end of the two opposite ends of the semiconductor layer 53 in the Z direction is in contact with the second side surface C2 to be coupled and electrically connected. In an actual implementable process, an end part that is of the semiconductor layer 53 and that is in contact with the first electrode 51 is flush with an end surface that is of the first electrode 51 and that is away from the second electrode 52. In addition, an end part that is of the semiconductor layer 53 and that is in contact with the second electrode 52 is flush with an end surface that is of the second electrode 52 and that is away from the first electrode 51.

With continued reference to FIG. 8b, because the gate 55 is located in the region between the first wall surface M1 and the second wall surface M2, a projected area of the storage unit 400 on the substrate may be further reduced, so that a size of the storage unit is further reduced.

To implement insulation between the semiconductor layer 53 and the gate 55, an insulation material is filled between the semiconductor layer 53 and the gate 55; to enable insulation between the gate 55 and the first electrode 51, an insulation material is filled between the first electrode 51 and the gate 55; and in addition, to enable insulation between the gate 55 and the second electrode 52, an insulation material is filled between the second electrode 52 and the gate 55. From a process perspective, an insulation layer may be simultaneously formed by using a deposition process on the first wall surface M1, the second wall surface M2, and the wall surface that is of the semiconductor layer 53 and that is used to face the gate 55.

In an implementable process, the first electrode 51, the sacrificial layer (which is defined as a sacrificial layer structure because the sacrificial layer needs to be finally removed), and the second electrode 52 may be sequentially stacked; then, a slot passing through the three layers of the stacked structure is provided, and the semiconductor layer 53 is formed on a side surface that is of the slot and that is close to the first electrode 51, the sacrificial layer, and the second electrode 52; then, the sacrificial layer is removed to form a concave cavity between the first electrode 51 and the second electrode 52; and then the gate dielectric layer 54 and the gate 55 are formed in the concave cavity, to produce the structure of the transistor Tr shown in FIG. 8b. From a perspective of a process of forming the structures shown in FIG. 8a and FIG. 8b, a producing process is simple and easy to implement. In particular, a semiconductor layer 53 of each storage unit 400 includes only a channel structure extending in the Z direction, so as to reduce sizes of a plurality of storage units in the Y direction parallel to the substrate, so that more storage units are formed on a unit surface of the substrate.

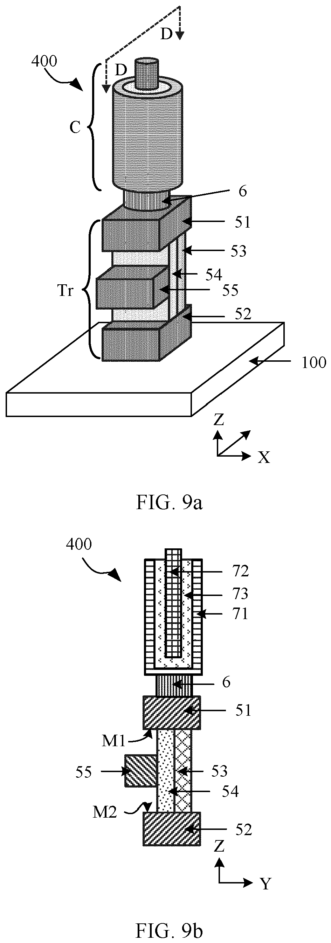

FIG. 9a and FIG. 9b are diagrams of a process structure of another storage unit 400. FIG. 9b is a cross-sectional view of FIG. 9a in a D-D direction. With reference to FIG. 9a and FIG. 9b, a similarity with the storage units 400 shown in FIG. 8a and FIG. 8b lies in that, the semiconductor layer 53 is also a vertical structure extending in the Z direction perpendicular to the substrate, and the similarity also lies in that, the gate 55 is disposed in a same position, to be specific, the gate 55 is located in the region between the first wall surface M1 and the second wall surface M2. A difference lies in that one of the two opposite ends of the semiconductor layer 53 in the Z direction is in contact with the first wall surface M1 to be coupled and electrically connected, and the other end of the two opposite ends of the semiconductor layer 53 in the Z direction is in contact with the second wall surface M2 to be coupled and electrically connected.

Similar to the storage units shown in FIG. 8a and FIG. 8b, because a semiconductor layer 53 of each storage unit 400 includes only a channel structure extending in the Z direction, the storage unit can be miniaturized, and storage density of the entire memory can be increased.

With reference to FIG. 9a and FIG. 9b, a material of the gate dielectric layer 54 used to insulate the gate 55 from the semiconductor layer 53 may be different from a material of an insulation layer used to insulate the gate 55 from the first electrode 51, and a material of the gate dielectric layer 54 may also be the same as a material of an insulation layer used to insulate the gate 55 from the second electrode 52.

In an implementable process, the second electrode 52, a first insulation layer, the gate 55, and a second insulation layer may be sequentially stacked in the Z direction shown in FIG. 9b, then a slot that ends at the second electrode 52 is provided in these stacked structures in the Z direction, and the gate dielectric layer 54 and the semiconductor layer 53 are sequentially stacked on a side surface of the slot, so that a material of the gate dielectric layer 54 is different from a material of the first insulation layer and a material of the second insulation layer. For example, the gate dielectric layer 54 may be formed by using a high dielectric constant dielectric material. Finally, the first electrode 51 is formed on the second insulation layer. Herein, the first insulation layer is used as an insulation structure for insulating the gate 55 from the second electrode 52, and herein, the second insulation layer is used as an insulation structure for insulating the gate 52 from the first electrode 51.

Based on the foregoing description of the process flow of the storage unit, it can be learned that the gate dielectric layer 54, the insulation structure used to insulate the gate 55 from the first electrode 51, and the insulation structure used to insulate the gate 55 from the second electrode 52 are formed in different process flows. Therefore, in the storage unit 400, the gate dielectric layer 54, the first insulation layer, and the second insulation layer may be made of different dielectric materials.

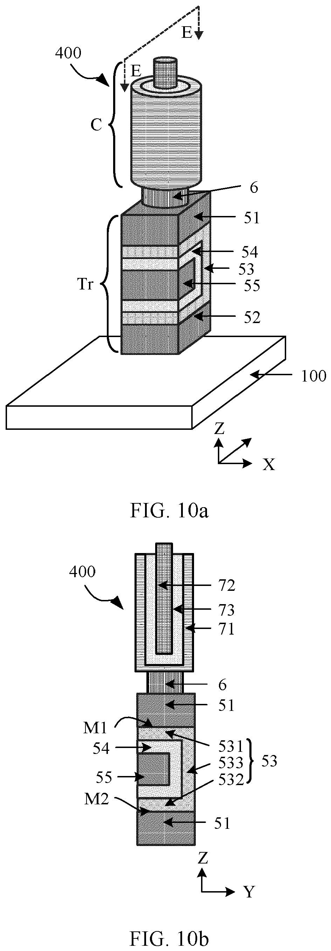

FIG. 10a and FIG. 10b are diagrams of a process structure of another storage unit 400. FIG. 10b is a cross-sectional view of FIG. 10a in an E-E direction. With reference to FIG. 10a and FIG. 10b, a difference from the storage unit 400 shown in FIG. 9a and FIG. 9b lies in that a semiconductor layer 53 in this embodiment includes a first portion 531 and a second portion 532 that both extend in the Y direction parallel to the substrate 100, and includes a third portion 533 extending in the Z direction perpendicular to the substrate 100. The third portion 533 is connected to the first portion 531 and the second portion 532. To be specific, the semiconductor layer 53 in this embodiment forms a concave cavity structure having an opening, the first portion 531 is disposed on a first wall surface M1, and the second portion 532 is disposed on a second wall surface M1.

From a perspective of performance of transistor forming such a structure, the first wall surface M1 of a first electrode 51 and the second wall surface M2 of a second electrode 52 each have a semiconductor layer. In this way, an ohmic contact area between the semiconductor layer and the first electrode 51 and an ohmic contact area between the semiconductor layer and the second electrode 52 may be increased, and therefore, resistance between the semiconductor layer and the first electrode 51 and resistance between the semiconductor layer and the second electrode 52 are reduced, thereby increasing a current flow rate and finally increasing a read/write speed of the storage unit.

From a perspective of a process of forming a transistor of this structure, when the transistor is formed, as shown in FIG. 9b, in a region between the first electrode 51 and the second electrode 52, a semiconductor layer structure is formed on the first wall surface M1 and the second wall surface M2 and between the first wall surface M1 and the second wall surface M2 by using a physical vapor deposition (physical vapor deposition, PVD) method or a chemical vapor deposition (chemical vapor deposition, CVD) method, the semiconductor layers on the first wall surface M1 and the second wall surface M2 do not need to be removed. In this way, a manufacturing process flow can be simplified, and a process difficulty can be reduced.

Based on the foregoing description of the structure of the storage unit 400, there is only a one-layer semiconductor layer structure in the Y direction parallel to the substrate 100. Compared with those for an existing two-layer semiconductor layer structure, the storage unit can be miniaturized, and storage density of the entire memory can be increased.

In addition, with reference to FIG. 10a and FIG. 10b, because the gate 55 is located in the concave cavity enclosed by the semiconductor layer 53, a size of the entire storage unit in the Y direction can be further reduced, and the size of the storage unit can be further reduced.

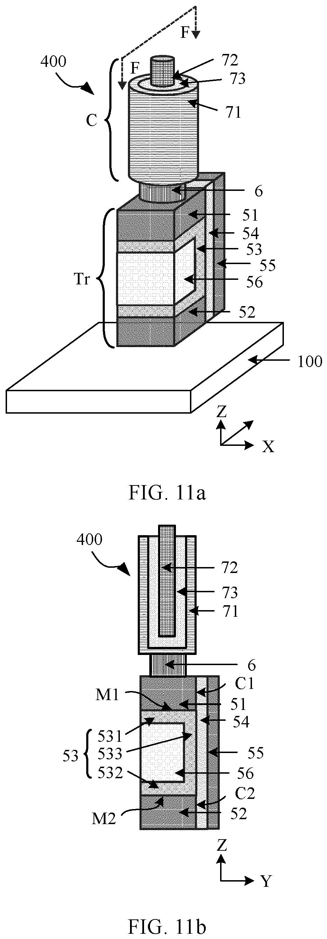

FIG. 11a and FIG. 11b are diagrams of a process structure of another storage unit 400. FIG. 11b is a cross-sectional view of FIG. 11a in an F-F direction. With reference to FIG. 11a and FIG. 11b, a similarity with the storage unit 400 shown in FIG. 10a and FIG. 10b lies in that a semiconductor layer 53 in this embodiment also includes a first portion 531 and a second portion 532 that both extend in the Y direction parallel to the substrate 100, and includes a third portion 533 extending in the Z direction perpendicular to the substrate 100. The third portion 533 is connected to the first portion 531 and the second portion 532. To be specific, the semiconductor layer 53 in this embodiment forms a concave cavity structure having an opening, the first portion 531 is disposed on a first wall surface M1, and the second portion 532 is disposed on a second wall surface M1. A difference from the storage units shown in FIG. 10a and FIG. 10b lies in that the gate 55 is disposed in a different position. In this embodiment, as shown in FIG. 11b, the gate 55 is located on one of the first side surface C1 and the second side surface C2, and the gate 55 is isolated from the first electrode 51, the second electrode 52, and the semiconductor layer 53 by the gate dielectric layer 54.

In an actual implementable process, an end part that is of the gate 55 and that is close to the first electrode 51 is flush with an end surface that is of the first electrode 51 and that is away from the second electrode 52. In addition, an end part that is of the gate 55 and that is close to the second electrode 52 is flush with an end surface that is of the second electrode 52 and that is away from the first electrode 51. Such a structure may also be defined as that the gate 55 is located between the first electrode 51 and the second electrode 52.

The first wall surface M1 of the first electrode 51 and the second wall surface M2 of the second electrode 52 each have a semiconductor layer. In this way, an ohmic contact area between the semiconductor layer and the first electrode 51 and an ohmic contact area between the semiconductor layer and the second electrode 52 may be increased, and therefore, resistance between the semiconductor layer and the first electrode 51 and resistance between the semiconductor layer and the second electrode 52 are reduced, thereby increasing a current flow rate and increasing a read/write speed of the storage unit.

In addition, as shown in FIG. 11b, the first portion 531, the second portion 532, and the third portion 533 forms a concave cavity having an opening, and the concave cavity is filled with another insulation layer 56.

In an implementable process, the second electrode, the sacrificial layer, and the first electrode may be sequentially stacked in the Z direction shown in FIG. 11b, then a slot that passes through the second electrode, the sacrificial layer, and the first electrode are provided in these stacked structures in the Z direction, and the gate dielectric layer 54 and the gate 55 are sequentially stacked on a side surface of the slot. Then, the sacrificial layer is removed to form a concave cavity between the first electrode 51 and the second electrode 52, the semiconductor layer 53 is filled in the concave cavity, and remaining space of the concave cavity is filled with an insulation material to form an insulation layer 56.

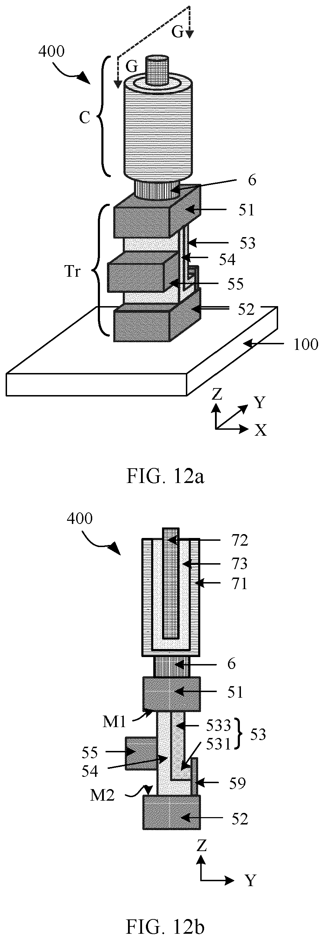

FIG. 12a and FIG. 12b are diagrams of a process structure of another storage unit 400. FIG. 12b is a cross-sectional view of FIG. 12a in a G-G direction. With reference to FIG. 12a and FIG. 12b, the semiconductor layer 53 in this embodiment includes a first portion 531 extending in a Y direction parallel to the substrate 100 and a third portion 533 extending in a Z direction perpendicular to the substrate 100, and the third portion 533 is connected to the first portion 531. One end of the third portion 533 is in contact with the first wall surface M1 of the first electrode 51, a connection electrode 59 is further disposed on the second electrode 52, and the first portion 531 is in contact with the connection electrode 59 to be coupled and electrically connected. In other words, the semiconductor layer 53 in this embodiment is of a structure approximating to an L-shaped structure, and the gate dielectric layer 54 is also of a structure approximating to an L-shaped structure.

A material of the connection electrode 59 herein may be the same as or different from a material of the second electrode 52.

Based on the foregoing description of the structure of the storage unit 400, there is only a one-layer semiconductor layer structure in the Y direction parallel to the substrate 100. Compared with those for an existing two-layer semiconductor layer structure, the storage unit can be miniaturized, and storage density of the entire memory can be increased.

In some optional implementations, as shown in FIG. 12b, a capacitor C includes a first electrode layer 71, a capacitor dielectric layer 73, and a second electrode layer 72. The capacitor dielectric layer 73 is sandwiched between the first electrode layer 71 and the second electrode layer 72. For example, as shown in FIG. 12b, the capacitor C is of a columnar structure. In an implementable process, a via may be formed in a dielectric layer. First, the first electrode layer 71 is formed on a bottom surface and a side surface of the via, then the capacitor dielectric layer 73 is formed on a bottom surface and a side surface of the first electrode layer 71, and finally, the second electrode layer 72 is formed in remaining space of the via. FIG. 12b shows only one implementable structure formed by a capacitor C. Certainly, the capacitor C may be alternatively of another structure.

To implement an electrical connection between the capacitor C and a transistor Tr, as shown in FIG. 12b, a conductive layer 6 may be disposed between the capacitor C and the transistor Tr, so that the first electrode layer 71 of the capacitor C is electrically connected to the first electrode 51 of the transistor Tr through the conductive layer 6.

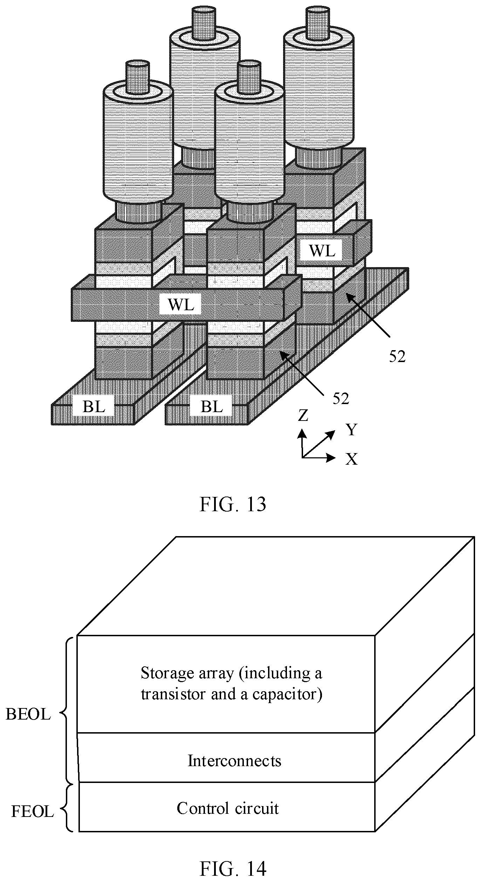

When there are a plurality of storage units of any one of the foregoing types, and the plurality of storage units are arranged in an array in the X direction, the Y direction, and the Z direction that are perpendicular to each other, a DRAM may be formed. For example, FIG. 13 shows an example of a 2 x 2 storage array structure.

The DRAM further includes a plurality of bit lines BLs and a plurality of word lines WLs. In a diagram of a process structure of the memory, the plurality of bit lines BLs may be arranged in parallel, and the plurality of word lines WLs may also be arranged in parallel. For example, as shown in FIG. 13, each bit line BL extends in a Y direction, the plurality of bit lines BLs are arranged in an X direction perpendicular to the Y direction, each word line WL extends in the X direction, and the plurality of word lines WL are arranged in the Y direction perpendicular to the X direction.

Further, still with reference to FIG. 13, when a bit line BL extends in the Y direction, second electrodes 52 in a plurality of storage units arranged in the Y direction are electrically connected to the same bit line BL. FIG. 14 shows one structure of a bit line BL. To be specific, a metal layer is formed on a side that is of a second electrode 52 and that is away from a first electrode 51, and the metal layer is used as the bit line BL. In some other optional implementations, two adjacent second electrodes 52 arranged in the Y direction may be connected by using a metal layer, so that a plurality of second electrodes 52 share the same bit line BL.

Still with reference to FIG. 13, when a word line WL extends in the X direction, gates 55 in a plurality of storage units arranged in the X direction are electrically connected to the same word line WL. FIG. 13 shows an implementable structure of the word line WL, to be specific, two adjacent gates 55 arranged in the X direction are connected by using a metal layer, so that a plurality of gates 55 share the same word line WL.

The memory provided in this application may be manufactured by using a back end of line (back end of line, BEOL) process. FIG. 14 is a conceptual diagram of a back end of line BEOL process. In FIG. 14, a control circuit is manufactured on a substrate by using a front end of line (front end of line, FEOL) process. The control circuit may include one or more of circuits: a decoder 320, a driver 330, a timing controller 340, a cache 350, or an input/output driver 360 that are shown in FIG. 4, and may further include another functional circuit. The control circuit may control a signal line (a word line WL and a bit line BL) in this embodiment of this application. After the front end of line FEOL process is completed, interconnects and a storage array are manufactured by using the back end of line BEOL process. The storage array herein, as described above, includes a plurality of corresponding transistors, a plurality of capacitors, and at least a part of a signal line (a word line WL and a bit line BL) in the plurality of storage units. The interconnects include not only interconnects connecting components in the control circuit, but also include another part of the signal line. The transistor and the capacitor in the storage array are manufactured by using the back end of line process, so that three-dimensional stacking can be implemented, and circuit density per unit area can be higher, thereby improving performance per unit area.

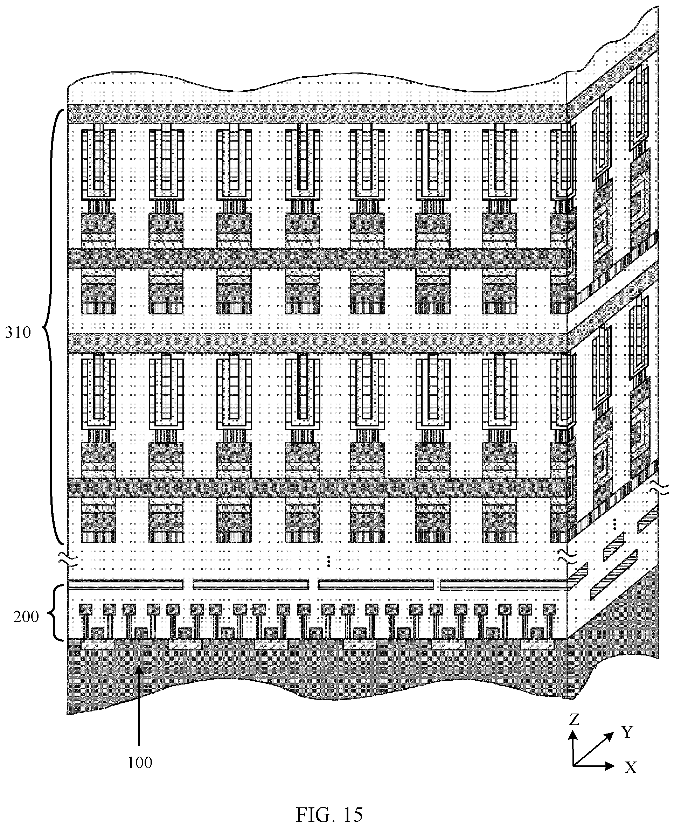

FIG. 15 is a three-dimensional structural diagram of a chip structure including the foregoing memory. It can be learned from the figure that a control circuit 200 is formed on a substrate 100 by using a front end of line FEOL process, and a storage array 310 is formed on the control circuit 200 by using a back end of line BEOL process. FIG. 15 shows an example of a two-layer storage array structure, and in a storage unit of the storage array, a transistor is close to a side of the substrate 100 relative to a capacitor.

The following provides a producing method of the memory in this application. For example, a control circuit is first formed on a substrate, interconnects are formed on the control circuit, and then a plurality of storage units disposed in an array are formed on the interconnects, and the control circuit is made electrically connected to the plurality of storage units by using the interconnects, so that read and write of the storage units are controlled by using the control circuit.

When a storage unit is formed, a first electrode and a second electrode are formed in a first direction perpendicular to the substrate, and a semiconductor layer, a gate, and a gate dielectric layer are formed. The semiconductor layer is provided on one of two opposite sides of the gate in a second direction, the semiconductor layer is separately electrically connected to the first electrode and the second electrode, and the gate dielectric layer is formed between the gate and the semiconductor layer, to produce a transistor. The method further includes: forming a capacitor, and making the capacitor electrically connected to the transistor, so as to form a storage unit of the memory. The second direction is a direction parallel to the substrate.

This application provides a specific producing method for producing a plurality of different storage unit structures, and the following separately provides detailed explanations.

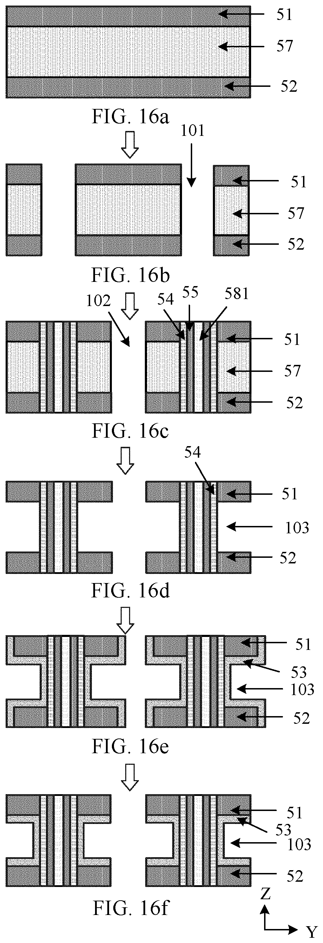

FIG. 16a to FIG. 16h are cross-sectional diagrams of a process structure after each step in a process of producing a storage unit in this application is completed.

As shown in FIG. 16a, a second electrode 52, a sacrificial layer 57, and a first electrode 51 are sequentially stacked in a first direction Z perpendicular to a substrate.

Materials of the first electrode 51 and the second electrode 52 herein have been described above, and are not described herein again. A material of the sacrificial layer 57 may be silicon oxide, aluminum oxide, silicon nitride, silicon, a silicon-germanium compound, or the like.

As shown in FIG. 16b, a plurality of first slots 101 arranged at intervals are provided in a second direction parallel to the substrate, namely, a Y direction, and the first slots 101 pass through the first electrode 51, the sacrificial layer 57, and the second electrode 52.

As shown in FIG. 16c, a gate dielectric layer 54 and a gate 55 are sequentially formed on a side surface of a first slot 101, and remaining space of the first slot 101 is filled with an insulation material, to form an insulation layer 581. Then, a second slot 102 is provided, and the second slot 102 is provided in an adjacent structure having a gate dielectric layer 54 and a gate 55, and the second slot 102 passes through the first electrode 51, the sacrificial layer 57, and the second electrode 52.

As shown in FIG. 16d, the sacrificial layer 57 is removed to form, between the first electrode 51 and the second electrode 52, a concave cavity 103 having an opening.

A surface that is in the first electrode 51 and that faces the second electrode 52 is a first wall surface, and a surface that is in the second electrode 52 and that faces the first electrode 51 is a second wall surface.

As shown in FIG. 16e, a semiconductor layer 53 is formed in the concave cavity 103. The semiconductor layer 53 is formed on each of a first wall surface of the first electrode 51, a second wall surface of the second electrode 52, and a side surface that is of the gate dielectric layer 54 and that is away from the gate 55. When the semiconductor layer 53 is formed, a process such as deposition may be used. For example, when a deposition method is used, as shown in FIG. 16e, the semiconductor layer 53 is also formed on each of a side surface of the first electrode 51 and a side surface of the second electrode 52.

As shown in FIG. 16f, the semiconductor layer 53 on the side surface of the first electrode 51 and the side surface of the second electrode 52 needs to be removed, for example, through dry etching, to obtain a structure shown in FIG. 16f.

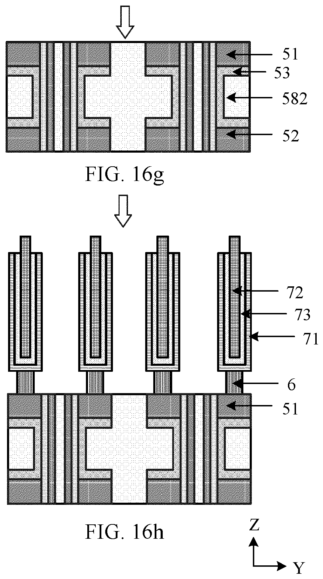

As shown in FIG. 16g, in the remaining space of the concave cavity, an insulation material is filled between the separated first electrode 51 and the separated second electrode 52, to form an insulation layer 582.

As shown in FIG. 16h, a conductive layer 6 is formed on the first electrode 51, and a capacitor C is formed on the conductive layer 6, so that the capacitor C is electrically connected to a transistor Tr through the conductive layer 6.

When the capacitor C is formed, a via that ends at the conductive layer 6 may be first formed in the dielectric layer on top of the conductive layer 6, and then a first electrode layer 71, a capacitor dielectric layer 73, and a second electrode layer 72 are sequentially formed in the via in a radial direction of the via, so that the first electrode layer 71 is electrically connected to the first electrode 51 through the conductive layer 6.

In some optional implementations, during performing of process steps shown in FIG. 16a, when the second electrode 52, the sacrificial layer 57, and the first electrode 51 are stacked, a metal layer may be formed on a side that is of the second electrode 52 and that is away from the first electrode 51, and when the first slot 101 and the second slot 102 are provided, none of the slots can pass through the metal layer. In the finally formed memory, the metal layer may be used as a bit line BL for electrically connecting second electrodes 52 of a plurality of storage units arranged in the Y direction.

Based on the description of the foregoing process steps, the formed semiconductor layer 53 is of a vertical structure that extends in a direction perpendicular to the substrate, and is disposed in parallel with the gate 55, instead of being disposed around a periphery of the gate 55. In this way, a size in the Y direction parallel to the substrate is significantly reduced, and each storage unit is miniaturized.

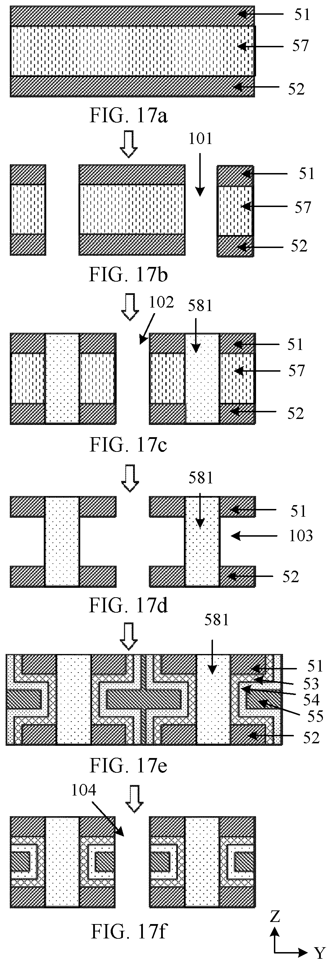

FIG. 17a to FIG. 17h are cross-sectional diagrams of a process structure after each step in another process of producing a storage unit in this application is completed.

As shown in FIG. 17a, a second electrode 52, a sacrificial layer 57, and a first electrode 51 are sequentially stacked in a first direction Z perpendicular to a substrate.

As shown in FIG. 17b, a plurality of first slots 101 arranged at intervals are provided in a second direction parallel to the substrate, namely, a Y direction, and the first slots 101 pass through the first electrode 51, the sacrificial layer 57, and the second electrode 52.

The process steps shown in FIG. 17a and FIG. 17b provided in this embodiment are the same as the process steps shown in FIG. 16a and FIG. 16b, and a corresponding structure may also be made by using a same material.

As shown in FIG. 17c, the first slot 101 is filled with an insulation material, to form an insulation layer 581. A second slot 102 is provided, and the second slot 102 is provided between adjacent insulation layers 581, and the second slot 102 passes through the first electrode 51, the sacrificial layer 57, and the second electrode 52.

As shown in FIG. 17d, the sacrificial layer 57 is removed to form, between the first electrode 51 and the second electrode 52, a concave cavity 103 having an opening.

As shown in FIG. 17e, a semiconductor layer 53, a gate dielectric layer 54, and a gate 55 are sequentially formed in the concave cavity 103.

When the gate 55 is formed, gates 55 of the two adjacent storage units are connected. As shown in FIG. 17e, the connected gates 55 need to be separated, so as to produce a structure that is shown in FIG. 17f and that is provided with a third slot 104.

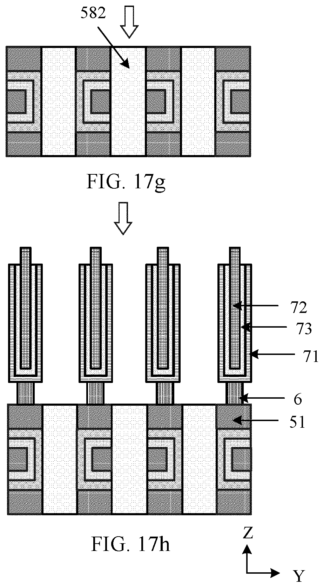

As shown in FIG. 17g, the third slot 104 is filled with an insulation material, to form an insulation layer 582.

As shown in FIG. 17h, a conductive layer 6 is formed on the first electrode 51, and a capacitor C is formed on the conductive layer 6, so that the capacitor C is electrically connected to a transistor Tr through the conductive layer 6.

Same as the foregoing process steps, during performing of process steps shown in FIG. 17a, when the second electrode 52, the sacrificial layer 57, and the first electrode 51 are stacked, a metal layer may be formed on a side that is of the second electrode 52 and that is away from the first electrode 51, and when the first slot 101, the second slot 102, and the third slot 104 are provided, none of the slots can pass through the metal layer. In the finally formed memory, the metal layer may be used as a bit line BL for electrically connecting second electrodes 52 of a plurality of storage units arranged in the Y direction.

Based on the description of the foregoing process steps, the formed semiconductor layer 53 is of a concave cavity structure having an opening, instead of being disposed around a periphery of the gate. Therefore, a size of the storage unit in the Y direction parallel to the substrate is significantly reduced, and each storage unit is miniaturized.

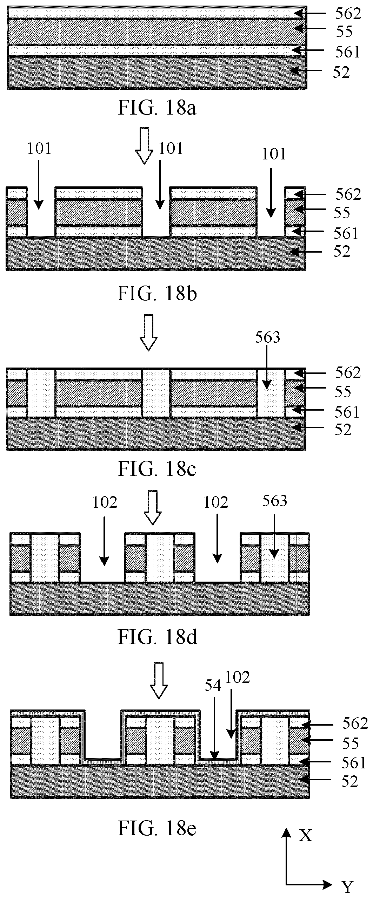

FIG. 18a to FIG. 18j are cross-sectional diagrams of a process structure after each step in a process of producing a storage unit in this application is completed.

As shown in FIG. 18a, a second electrode 52, an insulation layer 561, a gate 55, and an insulation layer 562 are sequentially stacked in a first direction Z perpendicular to a substrate.

As shown in FIG. 18b, a plurality of first slots 101 arranged at intervals are provided in a second direction parallel to the substrate, namely, a Y direction, and the first slots 101 pass through the insulation layer 562, the gate 55, and the insulation layer 561. In other words, the first slot 101 cannot pass through the second electrode 52, because the second electrode 52 herein may finally be used as a bit line BL of a storage array.

As shown in FIG. 18c, the first slot 101 is filled with an insulation material, to form an insulation layer 563.

As shown in FIG. 18d, a second slot 102 is further provided, and the second slot 102 is provided between adjacent insulation layers 563, and the second slot 102 passes through the insulation layer 562, the gate 55, and the insulation layer 561.

As shown in FIG. 18e, a gate dielectric layer 54 is formed in the second slot 102.

When the gate dielectric layer 54 is formed, a process such as deposition or sputtering may be used. For example, when a deposition method is used, the gate dielectric layer 54 is formed on each of a bottom surface and a side surface of the second slot 102 and an upper surface of the insulation layer 562.

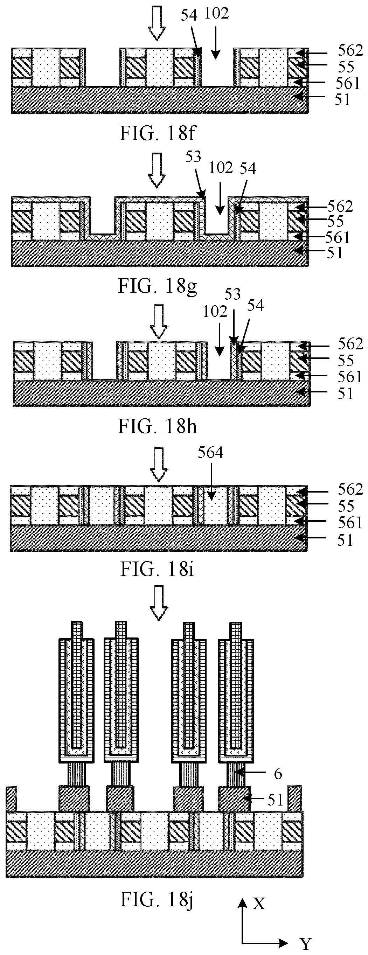

As shown in FIG. 18f, the bottom surface of the second slot 102 and the upper surface of the insulation layer 562 need to be removed, for example, through dry etching, to remove the bottom surface of the second slot 102 and the gate dielectric layer 54 on the upper surface of the insulation layer 562, so as to obtain a structure shown in FIG. 18f.

As shown in FIG. 18g, a semiconductor layer 53 is formed.

Same as a process of forming the gate dielectric layer 54, a process such as deposition or sputtering may also be used. In this way, as shown in FIG. 18g, the semiconductor layer 53 is formed on each of the bottom surface of the second slot 102, a side wall surface of the gate dielectric layer 54, and the upper surface of the insulation layer 562.

As shown in FIG. 18h, the semiconductor layer 53 on the bottom surface of the second slot 102 and the upper surface of the insulation layer 562 is further removed, to obtain a structure shown in FIG. 18h.

As shown in FIG. 18i, remaining space in the second slot 102 is filled with an insulation material, to form an insulation layer 564.

As shown in FIG. 18j, a first electrode 51, a conductive layer 6, and a capacitor C are formed on the insulation layer 562. Each capacitor C is electrically connected to a first electrode 51 of a corresponding transistor by using the conductive layer 6.

Compared with that in the process steps shown in FIG. 16a to FIG. 16h and FIG. 17a to FIG. 17h, a bit line BL structure in this embodiment is different, but second electrodes of a plurality of storage units arranged in a Y direction are directly connected together to form a bit line BL. Certainly, the process structure of the bit line BL shown in FIG. 16a to FIG. 16h and FIG. 17a to FIG. 17h may be alternatively used.

Based on the description of the foregoing process steps, the formed semiconductor layer 53 is of a vertical structure that extends in a direction perpendicular to the substrate, and is disposed in parallel with the gate 55. Similarly, a size in the Y direction parallel to the substrate is significantly reduced, and each storage unit is miniaturized.

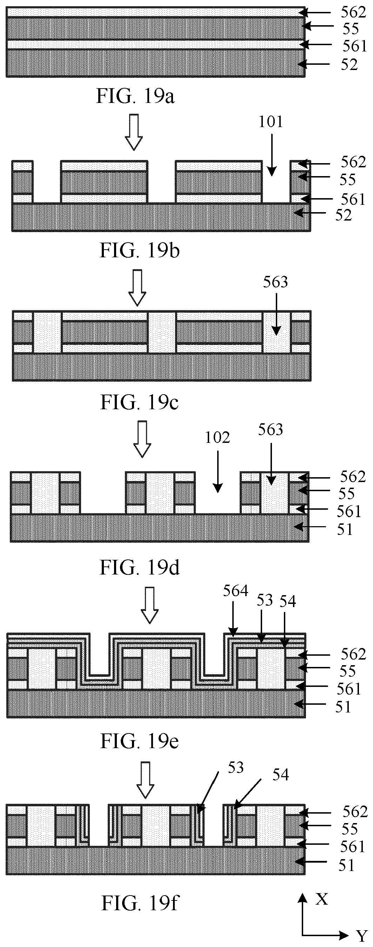

FIG. 19a to FIG. 19k are cross-sectional diagrams of another process structure after each step in a process of producing a storage unit in this application is completed.

As shown in FIG. 19a, a second electrode 52, an insulation layer 561, a gate 55, and an insulation layer 562 are sequentially stacked in a first direction Z perpendicular to a substrate.

As shown in FIG. 19b, a plurality of first slots 101 arranged at intervals are provided in a second direction parallel to the substrate, namely, a Y direction, and the first slots 101 pass through the insulation layer 562, the gate 55, and the insulation layer 561.

As shown in FIG. 19c, the first slot 101 is filled with an insulation material, to form an insulation layer 563.

As shown in FIG. 19d, a second slot 102 is further provided, and the second slot 102 is provided between adjacent insulation layers 563, and the second slot 102 passes through the insulation layer 562, the gate 55, and the insulation layer 561.

The process steps in FIG. 19a to FIG. 19d are the same as the process steps in FIG. 18a to FIG. 18d. In each same process step, a same process means may also be used.

As shown in FIG. 19e, a gate dielectric layer 54, a semiconductor layer 53, and an insulation layer 564 are sequentially formed in the second slot 102.

Different from the foregoing process method, in this process structure, after the gate dielectric layer 54 is formed, the gate dielectric layer 54 formed on the bottom surface of the second slot 102 does not need to be removed, but the semiconductor layer 53 is directly formed on the gate dielectric layer 54. In this way, the following case is avoided: when the gate dielectric layer 54 on the bottom surface of the second slot 102 is removed by using an etching process, the gate dielectric layer 54 on a side wall surface of the second slot 102 is polluted and final storage performance of the gate dielectric layer 54 is affected.

As shown in FIG. 19f, the insulation layer 564, the semiconductor layer 53, and the gate dielectric layer 54 on the bottom surface of the second slot 102, and the insulation layer 564, the semiconductor layer 53, and the gate dielectric layer 54 on the upper surface of the insulation layer 562 are removed, so that a structure shown in FIG. 19f is formed.

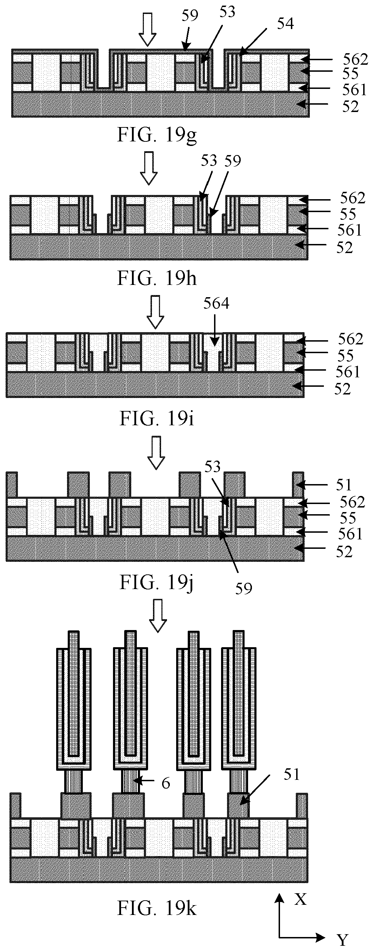

As shown in FIG. 19g, a connection electrode 59 is formed, to form the connection electrode 59 on the bottom surface of the second slot 102, the insulation layer 564, and the upper surface of the insulation layer 562.

As shown in FIG. 19h, the bottom surface of the second slot 102, the connection electrode 59 close to an opening of the second slot 102, and the upper surface of the insulation layer 562 are removed to form the connection electrode 59. In this way, the semiconductor layer 53 may be electrically connected to the second electrode 52 through the connection electrode 59.

As shown in FIG. 19i, remaining space in the second slot 102 is filled with an insulation material, to form an insulation layer 564.

As shown in FIG. 19j, the first electrode 51 is formed on the insulation layer 562.

As shown in FIG. 19k, a conductive layer 6 and a capacitor C are formed. Each capacitor C is electrically connected to a first electrode 51 of a corresponding transistor by using the conductive layer 6.

Based on the description of the foregoing process steps, the formed semiconductor layer 53 is of a structure approximating to an L-shaped structure, instead of being disposed around the gate 55. Therefore, a size in the Y direction parallel to the substrate is significantly reduced, and each storage unit is miniaturized.

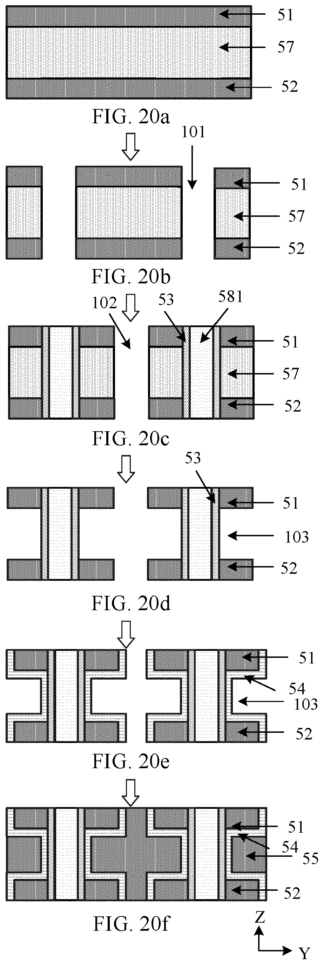

FIG. 20a to FIG. 20i are cross-sectional diagrams of another process structure after each step in a process of producing a storage unit in this application is completed.

As shown in FIG. 20a, a second electrode 52, a sacrificial layer 57, and a first electrode 51 are sequentially stacked in a first direction Z perpendicular to a substrate.

As shown in FIG. 20b, a plurality of first slots 101 arranged at intervals are provided in a second direction parallel to the substrate, namely, a Y direction, and the first slots 101 pass through the first electrode 51, the sacrificial layer 57, and the second electrode 52.

As shown in FIG. 20c, a semiconductor layer 53 is formed on a side surface of the first slot 101, and remaining space of the first slot 101 is filled with an insulation material, to form an insulation layer 581. A second slot 102 is provided, and the second slot 102 is provided between adjacent insulation layers 581, and the second slot 102 passes through the first electrode 51, the sacrificial layer 57, and the second electrode 52.

As shown in FIG. 20d, the sacrificial layer 57 is removed to form, between the first electrode 51 and the second electrode 52, a concave cavity 103 having an opening.

As shown in FIG. 20e and FIG. 20f, a gate dielectric layer 54 and a gate 55 are sequentially formed in the concave cavity 103.

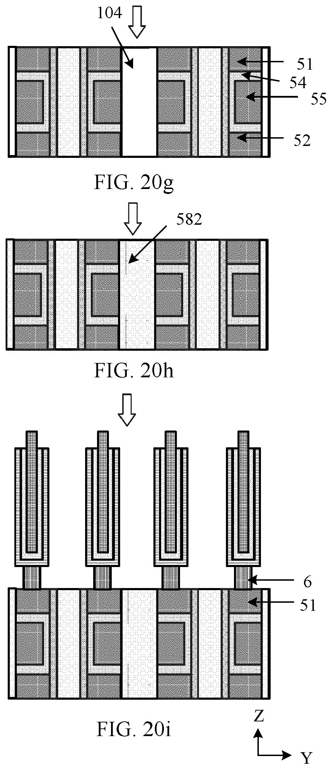

When the gate 55 is formed, gates 55 of the two adjacent storage units are connected. As shown in FIG. 20f, the connected gates 55 need to be separated, so as to produce a structure that is shown in FIG. 20g and that is provided with a third slot 104.

As shown in FIG. 20h, the third slot 104 is filled with an insulation material, to form an insulation layer 582.

As shown in FIG. 20i, a conductive layer 6 is formed on the first electrode 51, and a capacitor C is formed on the conductive layer 6, so that the capacitor C is electrically connected to a transistor Tr through the conductive layer 6.

Based on the description of the foregoing process steps, the formed semiconductor layer 53 is of a vertical structure, instead of being disposed around a periphery of the gate. Therefore, a size of the storage unit in the Y direction parallel to the substrate is significantly reduced, and each storage unit is miniaturized.

When the foregoing storage unit is produced by using different processes, a transistor in the storage unit is first formed, and then a capacitor is disposed on the transistor. In another optional implementation, a capacitor may be formed first, and then a transistor is formed on the capacitor.

In the descriptions of this specification, the described specific features, structures, materials, or characteristics may be combined in a proper manner in any one or more of embodiments or examples.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, comprising:
a substrate; and
a plurality of storage units formed on the substrate, wherein
each of the storage units comprises a transistor and a capacitor electrically connected to the transistor, and the transistor and the capacitor are arranged in a first direction perpendicular to the substrate;
the transistor comprises a gate, a semiconductor layer, a first electrode, a second electrode, and a gate dielectric layer; and
the first electrode and the second electrode are arranged in the first direction, the gate is located between the first electrode and the second electrode, the semiconductor layer is provided on one of two opposite sides of the gate in the second direction, the semiconductor layer is separately electrically connected to the first electrode and the second electrode, the gate and the semiconductor layer are isolated from each other by the gate dielectric layer, and the second direction is a direction parallel to the substrate.

2. The memory according to claim 1, wherein the semiconductor layer is of a vertical structure extending in the first direction, one of two opposite ends of the semiconductor layer in the first direction is in contact with the first electrode, and the other end is in contact with the second electrode.

3. The memory according to claim 2, wherein a surface that is in the first electrode and that faces the second electrode is a first wall surface, and a surface that is in the second electrode and that faces the first electrode is a second wall surface; and
one of the two opposite ends of the semiconductor layer in the first direction is in contact with the first wall surface, and the other end is in contact with the second wall surface.

4. The memory according to claim 2, wherein a surface that is in the first electrode and that faces the second electrode is a first wall surface, and a surface that is in the first electrode and that is adjacent to the first wall surface is a first side surface;
a surface that is in the second electrode and that faces the first electrode is a second wall surface, a surface that is in the second electrode and that is adjacent to the second wall surface is a second side surface, and the first side surface and the second side surface are located on a same side; and
one of the two opposite ends of the semiconductor layer in the first direction is in contact with the first side surface, and the other end is in contact with the second side surface.

5. The memory according to claim 1, wherein the semiconductor layer comprises a first portion and a second portion both of which extend in the second direction, and a third portion that extends in the first direction and that is connected to the first portion and the second portion;
a surface that is in the first electrode and that faces the second electrode is a first wall surface, and a surface that is in the second electrode and that faces the first electrode is a second wall surface; and
the first portion is disposed on the first wall surface, and the second portion is disposed on the second wall surface.

6. The memory according to claim 5, wherein the first portion, the second portion, and the third portion are connected to form an integral structure.

7. The memory according to claim 1, wherein the semiconductor layer comprises a first portion extending in the second direction and a third portion that extends in the first direction and that is connected to the first portion;
a surface that is in the first electrode and that faces the second electrode is a first wall surface, and a surface that is in the second electrode and that faces the first electrode is a second wall surface;
the memory further comprises a connection electrode, and the connection electrode is disposed on the second wall surface; and
the third portion is in contact with the first wall surface, and the first portion is in contact with the connection electrode.

8. The memory according to any one of claims 1 to 7, wherein the surface that is in the first electrode and that faces the second electrode is the first wall surface, and the surface that is in the second electrode and that faces the first electrode is the second wall surface; and
the gate is located in a region between the first wall surface and the second wall surface.

9. The memory according to any one of claims 1 to 7, wherein the surface that is in the first electrode and that faces the second electrode is the first wall surface, and the surface that is in the first electrode and that is adjacent to the first wall surface is the first side surface;
the surface that is in the second electrode and that faces the first electrode is the second wall surface, the surface that is in the second electrode and that is adjacent to the second wall surface is the second side surface, and the first side surface and the second side surface are located on the same side; and
the gate is located on a side close to the first side surface and the second side surface.

10. The memory according to any one of claims 1 to 9, wherein both the transistor and the capacitor are manufactured by using a back end of line process.

11. The memory according to any one of claims 1 to 10, wherein the capacitor comprises a first electrode layer, a capacitor dielectric layer, and a second electrode layer, the first electrode layer and the second electrode layer are isolated from each other by the capacitor dielectric layer, and the first electrode layer is electrically connected to the first electrode that is in the transistor and that is close to the capacitor.

12. The memory according to claim 11, wherein the first electrode layer extends in the first direction, and the second electrode layer surrounds a periphery of the first electrode layer.

13. The memory according to any one of claims 1 to 12, wherein the memory further comprises:
bit lines and word lines, wherein
the gate is electrically connected to the word lines, and the second electrode is electrically connected to the bit lines.

14. The memory according to claim 13, wherein
the bit lines all extend in the second direction;
the word lines extend in a third direction, and the second direction is perpendicular to the third direction;
the second electrodes of the plurality of storage units arranged in the second direction are electrically connected to a same bit line; and
the gates of the plurality of storage units arranged in the third direction are electrically connected to a same word line.

15. The memory according to claim 13 or 14, wherein the memory further comprises a controller, and the controller is configured to:
output a word line control signal to control a voltage on each of the word lines; and
output a bit line control signal to control a voltage on each of the bit lines.

16. An electronic device, comprising:
a processor; and
the memory according to any one of claims 1 to 15, wherein the processor is electrically connected to the memory.

17. The electronic device according to claim 16, wherein
the processor and the memory are integrated into a same chip.

18. A memory forming method, comprising:
forming a first electrode and a second electrode in a first direction perpendicular to a substrate, and forming a semiconductor layer, a gate, and a gate dielectric layer, wherein the semiconductor layer is provided on one of two opposite sides of the gate in a second direction, the semiconductor layer is separately electrically connected to the first electrode and the second electrode, and the gate dielectric layer is formed between the gate and the semiconductor layer, to form a transistor, wherein the second direction is a direction parallel to the substrate; and
forming a capacitor, and making the capacitor electrically connected to the transistor, so as to produce a storage unit.

19. The memory forming method according to claim 18, wherein before the storage unit is obtained, the forming method further comprises:
forming a control circuit on the substrate; and
forming, on the control circuit, interconnects that electrically connect the control circuit and the storage unit.
